# EUROPÄISCHE PATENTANMELDUNG

(11) **EP 1 583 157 A2**
(43) Veröffentlichungstag der Anmeldung: **05.10.2005**
(21) Anmeldenummer: 05005879.1
(22) Anmeldetag: 17.03.2005
(51) Int. Cl.: H01L 31/105

(54) **Pin-Photodiode**

(30) Priorität: 31.03.2004 DE 102004015832; 11.05.2004 DE 102004023303
(71) Anmelder: Osram Opto Semiconductors GmbH, 93049 Regensburg (DE)
(72) Erfinder: Reill, Wolfgang, 93080 Pentling (DE)
(74) Vertreter: Epping - Hermann - Fischer

(57) **Zusammenfassung**

Die Erfindung betrifft eine pin-Photodiode, mit einer photodetektierenden Schicht (3) aus einem Halbleitermaterial mit kleinerer Bandlücke, die einen p-dotierten Bereich aufweist und von einer Mantelschicht (4) aus einem Halbleitermaterial mit größerer Bandlücke bedeckt ist, wobei die Mantelschicht (4) über dem p-dotierten Bereich (7) der photodetektierenden Schicht (3) Ausnehmungen (5) aufweist.

Die pin-Photodiode ist dabei vor allem geeignet Licht eines möglichst großen Wellenlängenbereichs mit einer möglichst hohen Signalempfindlichkeit zu detektieren.

## Beschreibung

Die Erfindung betrifft eine pin-Photodiode.

Die Druckschrift US 5,053,837 beschreibt eine pin-Photodiode, die aus mehreren Schichten aufgebaut ist, die epitaktisch auf ein n-dotiertes InP-Substrat aufgewachsen sind. Die Schichtfolge ist dabei wie folgt: Auf das n-dotierte InP-Substrat ist eine n-dotierte InP-Pufferschicht aufgebracht, ihr folgt als photodetektierende Schicht eine n-dotierte InGaAs-Schicht. Die photodetektierende Schicht ist von einer n-dotierten InP-Mantelschicht bedeckt. Im Zentrum der InP-Mantelschicht wird durch Zn-Diffusion die Dotierung von n nach p geändert. Der Zn-dotierte Bereich erstreckt sich dabei bis zur n-dotierten InGaAs-Schicht und bildet auf diese Weise einen p-n-Übergang. Auf der Oberfläche des Zn-dotierten Bereichs der Mantelschicht befindet sich eine p-Elektrode und auf der Unterseite des InP-Substrats ist eine n-Elektrode zur elektrischen Kontaktierung der Photodiode aufgebracht.

Die Druckschrift US 5,053,837 beschreibt weiter eine InGaAs/InP-Photodiode ohne die oben beschriebene InP-Mantelschicht. In der Mitte der InGaAs-Oberfläche wird ein p-dotierter Bereich erzeugt, der sich mindestens 3 µm tief in die InGaAs-Schicht erstreckt. Eine ringförmige p-Elektrode wird um den p-dotierten Bereich der InGaAs-Schicht herum aufgebracht. Innerhalb des von der p-Elektrode umschlossenen Bereiches wird die p-dotierte InGaAs-Schicht bis zu einer Tiefe von 2 µm entfernt, so dass eine Öffnung entsteht durch die hindurch das Licht auf den p-n-Übergang auftreffen kann.

Technische Anwendung solcher Photodioden findet beispielsweise bei der Informationsübertragung mittels Glasfaserkabel statt, wo die Photodiode als Detektor eingesetzt wird. Die Photodioden kommen aber auch als Monitordiodenchips bei Halbleitermodulen zum Einsatz.

Aufgabe der vorliegenden Erfindung ist es eine pin-Photodiode anzugeben, mit einer möglichst guten Signalempfindlichkeit.

Diese Aufgabe wird gelöst durch eine pin-Photodiode nach Patentanspruch 1, mit einer photodetektierenden Schicht aus einem Halbleitermaterial mit kleinerer Bandlücke, die einen p-dotierten Bereich aufweist und von einer Mantelschicht aus einem Halbleitermaterial mit größerer Bandlücke als die Bandlücke des Halbleitermaterials der photodetektierenden Schicht bedeckt ist, wobei die Mantelschicht über dem p-dotierten Bereich der photodetektierenden Schicht Ausnehmungen aufweist. Vorteilhafte Ausgestaltungen der Erfindung sind Gegenstand von Unteransprüchen.

Der hier angegebenen pin-Photodiode liegt dabei die Idee zugrunde, dass eine Deck- oder Mantelschicht aus einem Halbleitermaterial mit einer größeren Bandlücke, die auf eine photodetektierende Schicht aus einem Halbleitermaterial mit kleinerer Bandlücke aufgebracht ist, den in der Photodiode erzeugten Dunkelstrom vermindern kann. Ein Grund für die Verminderung des Photostroms ist, dass Minoritätsladungsträger aus der photodetektierenden Schicht wegen der Heterobarriere zwischen Mantelschicht und photodetektierender Schicht nicht zur Oberfläche der Diode gelangen können und die Oberflächen-Rekombination von Landungsträgern damit weitgehend unterbunden wird. Da durch die Verminderung des Dunkelstroms das Hintergrundrauschen, in welches das Nutzsignal eingebettet ist reduziert wird, ermöglicht die beschriebene Mantelschicht einen Photodetektor mit erhöhter Signalempfindlichkeit. Die wenigstens eine Ausnehmung in der Mantelschicht erweitert das detektierbare Wellenlängenspektrum, da die Absorption von elektromagnetischer Strahlung durch die Mantelschicht im Bereich der Ausnehmung entfällt.

Der Aufbau der pin-Photodiode kann dabei vorteilhafterweise wie folgt sein: Als unterste Schicht weist die pin-Photodiode eine Metallschicht auf, die als Kathode fungiert und über die die Photodiode elektrisch kontaktiert werden kann. Diese Metallschicht ist auf die Unterseite eines Substrats aufgebracht, das bevorzugt aus einem Halbleitermaterial mit großer Bandlücke besteht. Dem Substrat folgt eine epitaktisch aufgewachsene Pufferschicht, vorzugsweise aus dem gleichen Halbleitermaterial wie das Substrat, die bevorzugt n-dotiert ist. Der Pufferschicht folgt dann die epitaktisch aufgewachsene photodetektierende Schicht nach.

In einer Ausführungsform der pin-Photodiode befindet sich an der Oberfläche der photodetektierende Schicht dabei ein p-dotierter Bereich. Dieser p-dotierte Bereich kann beispielsweise durch Diffusion eines p-Dotierstoffs erzeugt werden. Natürlich sind auch andere Dotiermethoden wie beispielsweise Ionen-Implantation oder ähnliches denkbar, um den p-dotierten Bereich zu erzeugen.

Die photodetektierende Schicht ist vorzugsweise von der Mantelschicht bedeckt, die das gleiche Halbleitermaterial wie das Substrat enthalten kann. Dabei weist die Mantelschicht über den p-dotierten Bereich Ausnehmungen auf, so dass der p-dotierte Bereich nur teilweise und nicht vollständig von der Mantelschicht bedeckt ist.

In einer bevorzugten Ausführungsform des Photodetektors bedeckt die Mantelschicht den p-dotierten Bereich von seinen seitlichen Rändern in einer bestimmten Breite lückenlos. Vorzugsweise bedeckt die Mantelschicht den p-dotierten Bereich dabei in einer Breite von mindestens 30 µm. Das heißt, an den Rändern der p-dotierten Schicht steht die Mantelschicht jeweils mindestens 30 µm ohne Unterbrechung in den p-dotierten Bereich über.

Der p-dotierte Bereich weist dabei von der Oberfläche der pin-Photodiode aus betrachtet bevorzugt eine rechteckige Form auf. Allerdings können auch andere Formen des p-dotierten Bereichs wie beispielsweise kreisförmige oder runde Formen sinnvoll sein.

In einer besonders bevorzugten Ausführungsform ist der p-dotierte Bereich dabei zumindest teilweise durch eine Entspiegelungsschicht bedeckt. Die Entspiegelungsschicht zeichnet sich dabei vor allem dadurch aus, dass sie bevorzugt aus einem Material gebildet ist das über einen sehr großen Wellenlängenbereich für elektromagnetische Strahlung durchlässig ist und möglichst wenig reflektierend ist. Die Entspiegelungsschicht kann dabei so auf den p-dotierten Bereich aufgebracht sein, dass sie an den seitlichen Rändern des p-dotierten Bereichs auf die Mantelschicht übersteht und dadurch auch Teile der Mantelschicht bedeckt.

In einer besonders bevorzugten Ausführungsform der pin-Photodiode ist der p-dotierte Bereich zumindest teilweise von einer Kontaktschicht bedeckt, die eine Anode bildet, über die die Photodiode elektrisch kontaktiert werden kann. Bevorzugt ist die Kontaktschicht dabei aus einem Metall gebildet. Teile der Kontaktschicht können auch die Entspiegelungsschicht bedecken. Somit können auch Teile der Entspiegelungsschicht von der Kontaktschicht bedeckt sein.

Im folgenden wird die beschriebene pin-Photodiode anhand eines Ausführungsbeispiels und der zugehörigen Figur näher erläutert.

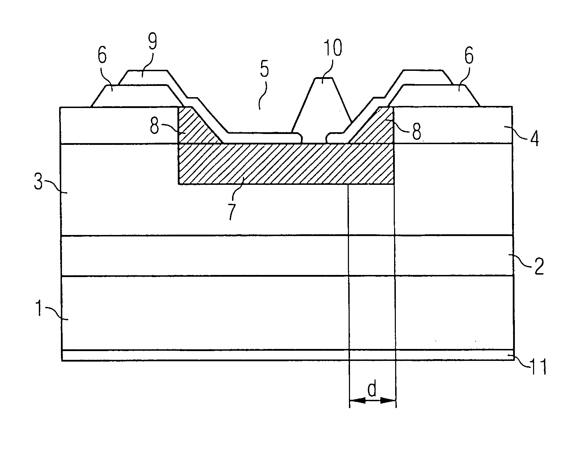

Die einzige Figur zeigt dabei einen Querschnitt durch eine InGaAs/InP pin-Photodiode.

Die dargestellten Bestandteile der Figur sowie die Größenverhältnisse der Bestandteile untereinander sind nicht als maßstabsgerecht anzusehen. Vielmehr sind einige Details der Figur zum besseren Verständnis übertrieben groß dargestellt.

Als Halbleitermaterial mit größerer Bandlücke wird in diesem Ausführungsbeispiel InP gewählt, während InGaAs als Halbleitermaterial mit einer kleineren Bandlücke gewählt wird. Diese Materialien stehen beispielhaft für Halbleitermaterialien mit größerer und kleinerer Bandlücke. Die Wahl der Materialien ist nicht einschränkend. Vielmehr können beliebige Kombinationen von Halbleitermaterialien mit größerer und kleinerer Bandlücke gewählt werden, je nach den Einsatzerfordernissen der Photodiode. Einsatzerfordernisse können dabei beispielsweise der zu detektierende Wellenlängenbereich, die benötigte Signalempfindlichkeit aber auch Temperatur- und Klimabedingungen allgemein am Einsatzort sein. Auch können die Kosten für die Photodiode wichtig bei der Materialwahl sein.

Die Figur zeigt den Querschnitt einer InGaAs/InP pin-Photodiode enthaltend eine Substratschicht 1. In dem beschriebenen Ausführungsbeispiel ist das Substrat 1 aus InP gebildet.

Auf das Substrat 1 ist epitaktisch eine Pufferschicht 2 aufgebracht, die wiederum InP enthält. Bevorzugt ist die Pufferschicht 2 zwischen 1 und 2 µm dick. Die Pufferschicht 2 ist dabei bevorzugt n-dotiert. Als n-Dotierstoff für die Pufferschicht 2 findet beispielsweise Si Verwendung. Die Pufferschicht 2 kann aber auch formal undotiert sein.

Aufgabe der Pufferschicht ist es, etwaige Versetzungen, die im InP-Substrat vorhanden sein können, davon abzuhalten, in die photodetektierende Schicht vorzudringen, wo sie sich beispielsweise negativ auf die Signalempfindlichkeit des Detektors auswirken können.

Der Pufferschicht 2 folgt eine InGaAs photodetektierende Schicht 3 nach, die ebenfalls epitaktisch auf die Pufferschicht 2 aufgebracht ist. Das Verhältnis von In, Ga und As wird bevorzugt so gewählt, dass der Gitterunterschied zwischen der Pufferschicht 2 und der photodetektierenden Schicht 3 möglichst gering ist und die photodetektierende Schicht 3 eine kleinere Bandlücke als die Pufferschicht 2 aufweist. Besonders bevorzugt besteht die photodetektierende Schicht 3 aus In_{0.53}Ga_{0.47}As. Die photodetektierende Schicht hat bevorzugt eine Dicke zwischen 2 und 4 µm.

Die photodetektierende Schicht bleibt vorzugsweise undotiert und fungiert als intrinsische photodetektierende Schicht 3 der pin-Photodiode. Es kann allerdings auch sinnvoll sein, je nach Anwendung, die photodetektierende Schicht 3 mit einer n-Dotierung zu versehen.

Auf die photodetektierende Schicht 3 folgt eine epitaktisch aufgewachsene Mantelschicht 4 die wiederum InP enthält. Die Mantelschicht 4 weist dabei eine größere Bandlücke als die photodetektierende Schicht 3 auf und trägt dadurch zur Verminderung des Dunkelstroms in der Photodiode bei. Bevorzugt ist die Mantelschicht 4 dabei n-dotiert und zwischen 0.5 und 1 µm dick.

Auf die Mantelschicht 4 ist eine strukturierte Diffusionsmaske 6 aufgebracht, die bevorzugt Siliziumnitrid enthält. Die Diffusionsmaske 6 ist so aufgebracht, dass bei einer nachfolgenden Diffusionsdotierung mit einem p-Dotierstoff im nicht maskierten Bereich der Mantelschicht 4, sowie der photodetektierenden Schicht 3, ein p-dotierter Bereich 7, eine sogenannte p-Wanne, entsteht.

Bevorzugt durch einen selektiven Ätzprozess sind Bereiche der Mantelschicht 4 über der p-Wanne entfernt, so dass an den so erzeugten Ausnehmungen 5 der Mantelschicht 4 die p-dotierte photodetektierende Schicht 3 freigelegt ist. Es sind aber auch andere Methoden zur Erzeugung der Ausnehmungen 5 denkbar. So ist es beispielsweise auch möglich mit Hilfe einer Maske den Bereich der Ausnehmungen 5 vor dem epitaktischen Aufwachsen der Mantelschicht 4 abzudecken. Die Maske muss dann nachträglich, beispielsweise durch einen Ätzprozess, entfernt werden. Die Ausnehmung 5 kann beispielsweise eine rechteckige oder auch eine runde Form aufweisen, aber auch andere geometrische Formen sind je nach Einsatzerfordernissen der Photodiode denkbar.

Wie in der Figur dargestellt, kann die Mantellschicht 4 auch genau eine Ausnehmung 5 aufweisen. Der Durchmesser der Ausnehmung beträgt dabei vorzugsweise zwischen 100 und 500 µm.

Außerdem sind an den seitlichen Rändern der Ausnehmung 5 in den Bereichen der Mantelschicht 4, die nicht von der Diffusionsmaske 6 bedeckt sind, p-dotierte, in einer Breite d überstehende, Mantelbereiche 8 gebildet. Diese überstehenden Mantelbereiche 8 sind Teile der Mantelschicht 4. Sie stehen lückenlos an den seitlichen Rändern des p-dotierten Bereichs 7 jeweils mindestens 30 µm über den p-dotierten Bereich 7 über und bedecken damit den p-dotierten Bereich 7 an seinen seitlichen Rändern lückenlos in dieser Breite. Durch diese überstehenden Mantelbereiche 8 ist gewährleistet, dass trotz der Ausnehmungen 5 durch das selektive Entfernen der Mantelschicht 4 über der photodetektierenden Schicht 3 der Photostrom noch ausreichend durch die Mantelschicht vermindert ist, so dass die Photodiode eine hohe Signalempfindlichkeit aufweist. Durch das Entfernen der Mantelschicht 8 über dem p-dotierten Bereich 7 ergibt sich weiter vorteilhaft eine Ausweitung des von der Photodiode zu detektierenden Wellenlängenbereichs.

So ist im Falle einer Photodiode, bei der der p-dotierte Bereich 7 vollständig von der Mantelschicht 4 bedeckt ist, die Empfindlichkeit für Wellenlängen kleiner ungefähr 950 nm wegen der Absorption von Strahlung durch die InP-Mantelschicht 4 stark vermindert.

Trifft nun im vorliegenden Ausführungsbeispiel Licht durch die Ausnehmung 5 auf den p-dotierten Bereich 7, so findet eine solche Absorption von Strahlung nicht statt, da die Mantelschicht 4 über dem p-dotierten Bereich 7 teilweise entfernt ist. Eine Photodiode dieser Art kann daher Licht eines Wellenlängenbereichs von ca. 680 nm bis ca. 1600 nm mit einer hohen Signalempfindlichkeit detektieren.

Auf Teile der Diffusionsmaske 6, den überstehenden Mantelbereich 8 und den p-dotierten Bereich 7 ist im vorliegenden Ausführungsbeispiel eine Entspiegelungsschicht 9 aufgebracht. Die Entspiegelungsschicht 9 enthält dabei bevorzugt Aluminiumoxid oder Siliziumnitrid. Auch andere Materialien sind denkbar. Die Entspiegelungsschicht 9 sollte dabei transparent über einen großen Wellenlängenbereich sein, so dass sie die Empfindlichkeit der Photodiode nicht mindert. Sie sollte nicht reflektierend sein und einen mechanischen Schutz des p-dotierten Bereichs 7 vor beispielsweise Schmutzpartikeln bilden. Die Entspiegelungsschicht 9 dient bevorzugt auch als Passivierungsschicht und bildet somit auch einen chemischen Schutz der Photodiode.

Die Entspiegelungsschicht 9 kann beispielsweise durch eine Einschichtentspiegelung gegeben sein. Die Dicke der Entspiegelungsschicht 9 ergibt sich dann aus der Wellenlänge bis zu der maximal entspiegelt werden soll und dem Brechungsindex, der für die Entspiegelungsschicht 9 verwendeten Materialien. Es ist aber auch möglich, dass die Entspiegelungsschicht 9 mehrere Schichten umfasst.

Weiter weist der p-dotierte Bereich 7 eine erste Kontaktschicht 10 auf, die leitend mit dem p-dotierten Bereich 7 verbunden ist und als Anode der Photodiode fungiert. Bevorzugt enthält die erste Kontaktschicht 10 dabei eines der folgenden Metalle: Platin, Gold, Titan.

Gegebenfalls muss die Entspiegelungsschicht 9 vor dem Aufbringen der Kontaktschicht 10 geöffnet werden.

Auf der Unterseite der Photodiode auf der Oberfläche des Substrats 1, die der photodetektierenden Schicht 3 abgewandt ist, ist eine zweite Kontaktschicht 11 aufgebracht, die bevorzugt eines der folgenden Materialien enthält: Germanium, Nickel, GeAu. Die zweite Kontaktschicht 11 fungiert dabei als Kathode der Photodiode, über die die Photodiode elektrisch kontaktiert wird.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Pin-Photodiode,
mit einer photodetektierenden Schicht (3) aus einem Halbleitermaterial mit kleinerer Bandlücke, die einen p-dotierten Bereich aufweist und von einer Mantelschicht (4) aus einem Halbleitermaterial mit größerer Bandlücke als die Bandlücke des Halbleitermaterials der photodetektierenden Schicht (3) bedeckt ist, wobei die Mantelschicht (4) über dem p-dotierten Bereich (7) der photodetektierenden Schicht (3) Ausnehmungen (5) aufweist.

2. Pin-Photodiode nach Anspruch 1,
bei der die Mantelschicht (4) den p-dotierten Bereich (7) von seinen seitlichen Rändern aus in einer Breite (d) von mindestens 30 µm lückenlos bedeckt.

3. Pin-Photodiode nach Anspruch 1 oder 2,
bei der der p-dotierte Bereich (7) zumindest teilweise von einer Entspiegelungsschicht (9) bedeckt ist.

4. Pin-Photodiode nach den Ansprüchen 1 bis 3,
bei der der p-dotierte Bereich (7) zumindest teilweise von einer ersten Kontaktschicht (10) bedeckt ist.

5. Pin-Photodiode nach den Ansprüchen 1 bis 4,
bei der die photodetektierende Schicht (3) InGaAs enthält.

6. Pin-Photodiode nach den Ansprüchen 1 bis 5,
bei der die Mantelschicht (4) n-dotiertes InP enthält.

7. Pin-Photodiode nach den Ansprüchen 1 bis 6,
bei der der p-dotierte Bereich (7) mit mindestens einem der folgenden Materialen dotiert ist: Zn, Be, Mg, Cd

8. Pin-Photodiode nach den Ansprüchen 1 bis 7,
bei der die Entspiegelungsschicht (9) wenigstens eines der folgenden Materialen enthält: Aluminiumoxid, Siliziumnitrid.

9. Pin-Photodiode nach den Ansprüchen 1 bis 8,
bei der die erste Kontaktschicht (10) mindestens eines der folgenden Metalle enthält: Ti, Pt, Au.

10. Pin-Photodiode nach den Ansprüchen 1 bis 9,
bei der der p-dotierte Bereich (7) mittels eines der folgenden Verfahren dotiert ist: Diffusion, Ionen-Implantation.

11. Pin-Photodiode nach den Ansprüchen 1 bis 10,
bei der die Mantelschicht (4) eine Dicke zwischen 0,5 und 1,0 µm aufweist.

12. Pin-Photodiode nach den Ansprüchen 1 bis 11,
bei der die photodetektierende Schicht (3) eine Dicke zwischen 2,0 und 4,0 µm aufweist.

13. Pin-Photodiode nach den Ansprüchen 1 bis 12,
bei der der p-dotierte Bereich (7) von der Oberfläche der pin-Photodiode aus betrachtet eine der folgenden Formen aufweist: rechteckig, kreisförmig, rund.
